Europäisches Patentamt

European Patent Office

Office européen des brevets

(11) Numéro de publication: **0 237 425 B1**

(12) **FASCICULE DE BREVET EUROPEEN**

(45) Date de publication de fascicule du brevet:
06.03.91

(51) Int. Cl.⁵: **H01L 27/10**, H01L 21/82, //H03K19/173

(21) Numéro de dépôt: 87400496.3

(22) Date de dépôt: 06.03.87

(54) **Circuit intégré d'architecture nouvelle et procédé de fabrication.**

(30) Priorité: **12.03.86 FR 8603507**

(43) Date de publication de la demande:
**16.09.87 Bulletin 87/38**

(45) Mention de la délivrance du brevet:
**06.03.91 Bulletin 91/10**

(84) Etats contractants désignés:
**AT DE ES FR GB IT NL**

(56) Documents cités:
**EP-A- 0 090 704**
**US-A- 4 525 809**

**PROCEEDINGS OF THE IEEE 1985 CUSTOM INTEGRATED CIRCUITS CONFERENCE, Portland, Oregon, 20-23 mai 1985, pages 15-17, IEEE; A. HUI et al.: "A 4.1K gates double metal HCMOS sea of gates array"**

(73) Titulaire: **THOMSON SEMICONDUCTEURS**
**101, bld Murat**
**F-75016 - Paris(FR)**

(72) Inventeur: **Borel, Joseph**
**THOMSON-CSF SCPI 19, avenue de Messine**
**F-75008 Paris(FR)**
Inventeur: **Michard, Jean**
**THOMSON-CSF SCPI 19, avenue de Messine**
**F-75008 Paris(FR)**
Inventeur: **Zardi, Eric**
**THOMSON-CSF SCPI 19, avenue de Messine**
**F-75008 Paris(FR)**

(74) Mandataire: **de Beaumont, Michel et al**
**1bis, rue Champollion**
**F-38000 Grenoble(FR)**

## Description

La présente invention concerne le structure générale des circuits intégrés et les procédés de fabrication qui permettent de réaliser ces circuits.

Les utilisateurs de circuits intégrés ont des exigences très variables concernant les spécifications de structure et de fonctionnement des circuits intégrés dont ils ont besoin.

Cela oblige les fabricants à changer souvent de configuration de circuits pour satisfaire des demandes de circuits très différents les uns des autres.

Si la fabrication porte sur un circuit à fabriquer en grande série on peut amortir les coûts de conception des topographies et de fabrication des circuits correspondants même si le circuit est très complexe.

Mais si la fabrication porte sur des petites séries, le coût de conception des topographies et la fabrication correspondante des masques ne peuvent plus être amortis même si le circuit est simple.

C'est pourquoi, à côté des procédés de conception et de fabrication classiques destinés aux grandes séries et bien adaptés aux circuits complexes (conception de topographie optimisée pour un besoin spécifique et fabrication d'un seul produit correspondant à cette topographie), on a proposé pour des circuits simples et des petites séries le concept de réseaux prédiffusés. Dans ce concept, la configuration principale du circuit est figée, seules les dernières étapes de fabrication, et plus précisément celles qui correspondent à la réalisation d'interconnexions conductrices entre des éléments de circuit, peuvent varier en fonction des besoins d'un utilisateur. Ces dernières étapes s'appellent étapes de personnalisation du circuit. L'utilisateur fournit ses spécifications, des interconnexions sont dessinées pour répondre à ces spécifications, sans toucher à la disposition figée des autres couches de la topographie, et le circuit intégré personnalisé peut être produit sur la base de la topographie globale comprenant les couches inférieures de configuration figée et les couches supérieures (en général quatre) de configuration variable.

Non seulement les coûts et les délais de conception sont réduits puisque la partie correspondant à la configuration figée est répartie sur un grand nombre d'utilisateurs ou d'applications, mais les coûts de fabrication sont réduits (seuls quatre masques spécifiques doivent être réalisés pour une application particulière) et les délais de fabrication sont également réduits puisqu'on peut fabriquer à l'avance des stocks de circuits intégrés comportant la configuration figée sans interconnexions.

On comprendra aisément que ce concept de réseau prédiffusé offre donc des avantages considérables, mais aussi que ses possibilités sont limitées du point de vue de la complexité des circuits qu'on peut réaliser, surtout à cause de l'encombrement des interconnexions entre les éléments de circuit qui sont à des positions figées (donc par définition non optimisées en fonction de l'application).

Pour mieux faire comprendre ces limitations, on va expliquer d'une part la structure générale d'un réseau logique prédiffusé et d'autre part des améliorations qui ont été apportées au concept de réseau prédiffusé pour augmenter leur domaine d'application vers des complexités croissantes.

Un réseau prédiffusé comprend en général des rangées de transistors, ou de paires de transistors, ou de microcellules de quelques transistors ; ces transistors, ou paires, ou microcellules sont au départ non connectés les uns aux autres. Ils font partie de la configuration figée ; ils sont disposés régulièrement avec un pas constant entre les rangées et les colonnes. Lors de la "personalisation" du circuit, les microcellules sont connectées entre elles par des interconnexions locales pour former des cellules ayant des fonctions désirées ; les cellules sont elles-mêmes connectées entre elles par des interconnexions générales qui passent dans des zones reservées aux interconnexions, situées entre les rangées ou les colonnes de microcellules. Ces zones réservées aux interconnexions sont appelées canaux de routage.

L'encombrement des interconnexions dans les canaux de routage croît très vite avec la complexité du circuit à réaliser.

Dans une conception plus récente que l'on trouvera décrite en détail dans le brevet EP-A-00 90 704 les canaux de routage sont supprimés; les rangées de microcellules sont toutes adjacentes les unes aux autres et remplissent tout l'espace réservé au réseau prédiffusé ; les interconnexions générales entre cellules passent audessus de rangées de microcellules non utilisées mais subsistant dans la configuration finale du circuit réalisé. Il en résulte une plus grande souplesse de réalisation des interconnexions puisqu'on n'est pas tenu de faire passer les interconnexions dans des canaux de routage prédéfinis ayant une surface limitée. Ce concept de réseau prédiffusé sans canaux de routage d'interconnexions est appelé réseau à interconnexions libres ou encore réseau du type "mer de portes", en anglais "sea of gates".

Le document US-A-4 525 809 concerne un circuit comportant des portes précâblées et un double niveau d'interconnexion dans des zones reservées entre les rangées ou les colounes de microcellules.

Avec la complexité croissante des circuits demandés par les utilisateurs même pour des petites séries, et avec la demande de fonctions électroniques spécifiques comme des mémoires qui ne peuvent être réalisées efficacement à partir d'un réseau prédiffusé de transistors conçu plus spécialement pour la réalisation de fonctions logiques (portes, bascules, etc...), sont apparus des circuits prédiffusés tentant de conserver les avantages du concept de configuration prédiffusée (coûts et délais de conception réduits, coûts et délais de fabrication réduits), tout en réduisant leurs limitations.

Ces circuits comportent dans leur configuration prédiffusée d'une part une ou plusieurs zones constituant chacune un réseau prédiffusé classique (rangées de transistors ou de paires de transistors, ou de microcellules à transistors), et d'autre part des macrocellules prédiffusées à fonctions électroniques complexes ou spécifiques dont la topographie est réalisée en vue d'une optimisation de l'encombrement, c'est-à-dire pas du tout à partir de réseaux réguliers de transistors.

Dans ce type de circuit prédiffusé à macrocellules complexes, on peut imaginer que la zone constituant le réseau prédiffusé de transistors soit constituée classiquement avec des rangées de transistors séparés par des canaux de routage d'interconnexions ou bien qu'elle soit constituée en réseau prédiffusé à interconnexions libres du type "mer de portes".

Mais l'architecture de ces circuits est toujours la suivante : la surface du circuit intégré comprend des zones réservées à des macrocellules prédiffusées, et des zones réservées à des réseaux prédiffusés de transistors ou de microcellules, ces dernières étant destinées à la réalisation de cellules logiques par interconnexion locale des microcellules lors de la personnalisation du circuit ; entre les zone de macrocellules et les zones de réseaux de microcellules sont prévus des intervalles pour permettre le passage des interconnexions générales qui doivent être réalisées entre les cellules et les macrocellules.

Les circuits ainsi obtenus paraissent particulièrement avantageux par leurs possibilités puisqu'ils incorporent à la fois des macrocellules complexes et des possibilités de réaliser à volonté des interconnexions et des cellules logiques plus simples en fonction des besoins d'un utilisateur. Mais ces circuits sont sujets à des limitations dues aux possibilités réduites de réalisation de cellules dans la zone prédiffusée et dues aussi naturellement à la nature figée de la configuration des macrocellules complexes.

La présente invention propose une nouvelle architecture de circuit intégré permettant non seulement d'améliorer considérablement les possibilités et les performances des circuits fabriqués selon le processus industriel de prédiffusion (processus dans lequel la plupart des niveaux de masquage ont une configuration figée et dans lequel les circuits sont même éventuellement fabriqués et stockés avec une configuration figée en attendant les étapes de conception et fabrication personnalisée des interconnexions), mais aussi d'améliorer les coûts et délais de conception de circuit intégrés qui ne font pas appel à un processus industriel de prédiffusion.

A partir de cette architecture nouvelle adaptée à des circuits prédiffusés comme à des circuits entièrement spécifiques, la présente invention propose un processus industriel nouveau permettant d'améliorer les possibilités ainsi que les coûts et délais de conception de circuits intégrés entièrement spécifiques (non prédiffusés), ce processus utilisant de manière inattendue les propriétés d'une architecture normalement prévue pour des circuits destinés à subir un processus de prédiffusion. On expliquera plus loin cette architecture et le processus industriel selon l'invention, mais il est important de faire remarquer ici que les architectures de circuits intégrés sont étroitement dépendantes de la nature du processus industriel et que les architectures de circuits prédiffusés ne sont normalement pas les mêmes que les architectures de circuits spécifiques.

La structure de circuit intégré proposée par la présente invention est la suivante: des macrocellules de topographie compacte, correspondant chacune à une fonction complexe ou spécifique accupent des zones espacées les unes des autres dans la surface disponible pour le circuit, les intervalles entre ces zones de macrocellules sont entièrement remplis de rangées adjacentes de transistors, des interconnexions locales sont prévues entre certains de ces transistors pour former des cellules logiques de topographie moins compacte, et des interconnexions générales sont prévues au-dessus de transistors non utilisés dans ces rangées, pour relier les cellules entre elles, les macrocellules entre elles, et les cellules avec les macrocellules.

Les interconnexions s'étendent entre des positions de contacts d'accès aux transistors et aux macrocellules, contacts d'accès qui sont de préférence tous choisis parmi des points d'un réseau régulier dont le pas est celui des transistors des rangées adjacentes.

Dans le cas d'un circuit de type prédiffusé, les zones de macrocellules ont une position et une configuration figée au moins en ce qui concerne les niveaux prédiffusés, mais tout l'espace disponible entre ces zones, c'est-à-dire la totalité ou la quasitotalité du reste de la surface disponible de circuit intégré est rempli de rangées de transistors prédiffusés pouvant servir à réaliser des fonctions logiques de liaison entre les macrocellules en fonction des spécifications de l'utilisateur.

Dans le cas d'un circuit spécifique, qui n'est pas destiné à être traité industriellement selon un processus de prédiffusion, cette architecture nouvelle, inattendue pour un circuit non prédiffusé, facilite le processus de fabrication en réduisant les coûts et les délais de conception ; le processus de fabrication est en effet le suivant :

On utilise une bibliothèque de topographies de cellules de circuits intégrés comprenant d'une part des macrocellules à fonctions électroniques complexes ou spécifiques optimisées du point de vue de l'encombrement et du fonctionnement, et d'autre part des microcellules de transistors destinées à être juxtaposées en rangées pour former un réseau régulier de type "mer de portes" permettant la réalisation de cellules logiques au moyen d'interconnexions locales entre les microcellules, les macrocellules pouvant être interconnectées entre elles ou avec les cellules logiques par des interconnexions générales aboutissant à des contacts d'accès prévus à cet effet dans les macrocellules et les microcellules.

On choisit en fonction des spécifications d'un utilisateur les macrocellules à utiliser et on modifie éventuellement les topographies de ces macrocellules en fonction de ces spécifications. On met en place globalement ces macrocellules à des positions espacées les unes des autres dans une surface disponible destinée à contenir la topographie globale du circuit intégré à réaliser. On remplit entièrement l'espace entre les macrocellules avec des microcellules disposées en rangées adjacentes juxtaposées sans espacement de routage d'interconnexions entre ces rangées. On termine la conception de la topographie globale par la réalisation de configurations d'interconnexions locales entre microcellules pour former des cellules logiques, et d'interconnexions générales entre les cellules, entre les macrocellules, et entre les cellules et les macrocellules, les interconnexions générales passant au-dessus de microcellules inutilisées.

Enfin, on fabrique les circuits intégrés par reproduction sur un substrat de circuit intégré de la topographie ainsi réalisée. Là encore, de préférence, les positions des macrocellules sont choisies telles que leurs contacts d'accès sont à des positions d'un réseau régulier de positions de contacts d'accès ayant un pas constant qui correspond au pas d'espacement des microcellules de transistors.

D'autres caractéristiques et avantages de l'invention apparaîtront à la lecture de la description détaillée qui suit et qui est faite en référence aux dessins annexés dans lesquels :

- la figure 1 représente schématiquement une topographie globale de circuit intégré de la technique antérieure,
- la figure 2 représente schématiquement une topographie de circuit intégré ayant l'architecture proposée selon la présente invention.

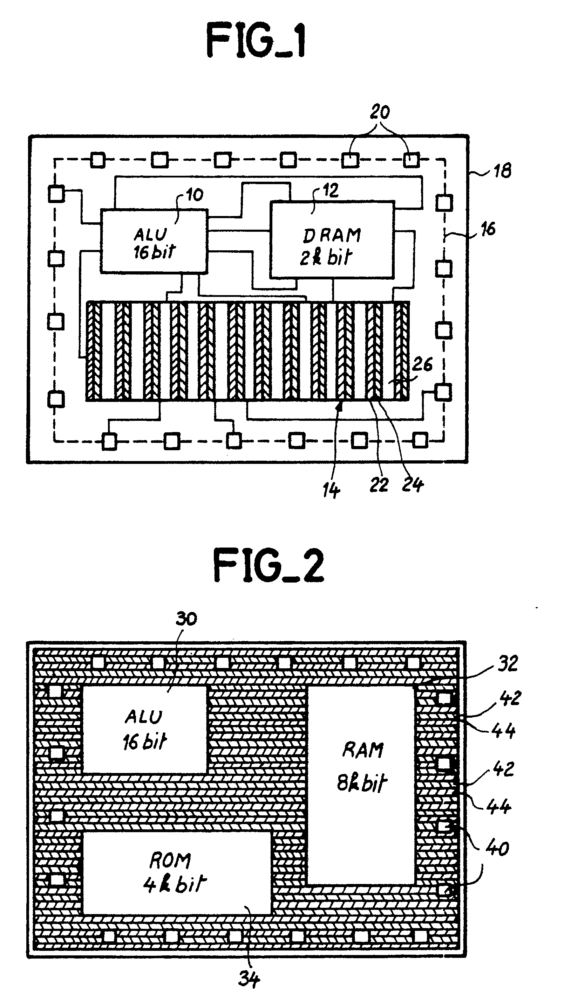

Le circuit intégré de type prédiffusé représenté à la figure 1 à titre d'exemple comprend une unité arithmétique et logique 10 travaillant sur 16 bits, une mémoire vive dynamique 12 capable de stocker 2048 bits, et un réseau 14 de 3000 microcellules de transistors pouvant être interconnectées à volonté pour former des cellules logiques.

Ces trois blocs sont placés au centre de la surface centrale disponible de la puce. Cette surface centrale est délimitée par un rectangle tireté 16, le contour extérieur de la puce étant désigné par la référence 18.

Des plots de contact 20 pour la liaison avec l'extérieur sont placés à la périphérie de la puce, ainsi éventuellement que quelques éléments de circuit non représentés tels que des amplificateurs de sortie directement reliés aux plots de contact 20. A titre d'exemple, on a dessiné la limite de la surface de puce disponible telle que les plots 20 soient situés sur cette limite, mais les plots peuvent être soit compris dans la surface disponible soit à l'extérieur.

Le réseau 14 de microcellules de transistors à été dessiné en représentant en traits hachurés dans un sens des rangées 22 de transistors à effet de champ à canal N et en traits hachurés dans l'autre sens des rangées 24 de transistors à effet de champ à canal P, avec des canaux 26 de routage d'interconnexions entre les rangées ou groupes de rangées de transistors.

Dans un exemple on peut considérer que chaque microcellule prédiffusée comprend un transistor à canal P et un transistor N adjacent.

Les intervalles entre le bloc 10 (unité arithmétique et logique), le bloc 12 (mémoire dynamique) et le bloc 14 (réseau de portes), sont libres et sont destinés au passage des interconnexions générales nécessaires (effectuées à la demande en fonction des spécifications de l'utilisateur) entre les blocs 10, 12, et 14. Seules quelques interconnexions ont été représentées pour ne pas alourdir la figure, mais il est évident que ces interconnexions sont dans la pratique très nombreuses.

On rappelle que dans ce circuit intégré, les blocs 10 et 12 sont des macrocellules de topographie compacte dont les interconnexions internes ont une configuration figée (ou pratiquement figée) ; au contraire le bloc 14 est un réseau de topographie régulière dont les interconnexions sont dessinées à la demande d'un utilisateur pour réaliser des cellules de topographie non compacte.

La topographie schématique indiquée à la figure 1 est une topographie utilisée uniquement pour un circuit prédiffusé. Un circuit possédant une topographie dont tous les niveaux de masquage sont entièrement conçus pour une utilisation particulière n'a normalement pas cette configuration.

L'architecture proposée à la figure 2, est destinée à améliorer les possibilités et les coûts de réalisation de circuits intégrés prédiffusés ou non prédiffusés. Les améliorations portent :

- sur la possibilité d'augmenter la complexité des circuits prédiffusés,
- sur l'augmentation des performances (telles que la vitesse de fonctionnement) liées à la disposition ou à la longueur des interconnexions,
- sur la réduction des coûts et délais de conception (pour des circuits intégrés non prédiffusés).

L'architecture du circuit intégré de la figure 2 est caractérisée par le fait que des blocs correspondant chacun à une macrocellule ayant une topographie compacte sont espacés les uns des autres dans la surface disponible de la puce et que l'intervalle entre ces blocs est entièrement rempli de rangées de transistors ou de microcellules de transistors sans canaux de routage d'interconnexions entre ces rangées, de sorte qu'on puisse prévoir à n'importe quel endroit de la surface disponible soit des cellules logiques réalisées par interconnexion locale de microcellules, soit des interconnexions générales passant au-dessus de microcellules non connectées.

Sur la figure 2 on a représenté une macrocellule 30 constituant une unité arithmétique et logique fonctionnant sur 16 bits, une macrocellule 32 constituant une mémoire dynamique de 8 kilobits, une macrocellule 34 constituant une mémoire morte de 4 kilobits.

Les macrocellules sont dessinées chacune avec une topographie compacte c'est-à-dire avec un encombrement global beaucoup plus réduit que si ces macrocellules devaient être réalisées à l'aide des microcellules d'un réseau régulier de type "réseau prédiffusé".

Les intervalles entre les macrocellules, sur la totalité de la surface disponible de la puce sont remplis justement par un réseau régulier de microcellules de type réseau prédiffusé.

On peut prévoir que la surface disponible de la puce s'étend même au delà du périmètre défini par les plots de contact de connexion vers l'extérieur (plots 40 sur la figure 2) ; pour illustrer cela, on a représenté à la figure 2 des rangées de microcellules s'étendant sur la quasi-totalité de la surface de la puce entre les macrocellule et autour d'elles, y compris éventuellement sous les plots de contact 40 ; les amplificateurs de sortie connectés aux plots peuvent alors eux-mêmes être réalisés par les transistors du réseau de microcellules ou bien par des blocs de topographie compacte placés à proximité des plots et entourés par le réseau de microcellules.

Le réseau de microcellules remplissant les intervalles entre les macrocellules 30, 32, 34 est du type "mer de portes", constitué de rangées adjacentes de microcellules ou de transistors, sans canaux de routage. On a représenté symboliquement des rangées 42 hachurées dans un sens (rangées de transistors à canal N), et des rangées 44 hachurées dans un autre sens (rangées de transistors à canal P), ces rangées alternées couvrant toute la surface disponible entre les macrocellules.

Pour faciliter le tracé automatique des interconnexions générales entre les macrocellules, ou entre les cellules et les macrocellules, la configuration interne des macrocellules et la position de ces macrocellules sont choisies telles que les interconnexions qui doivent partir de ces macrocellules puissent partir de positions de contacts d'accès qui ne sont pas n'importe où : ces contacts d'accès sont à des positions d'un réseau régulier de positions qui est le prolongement du réseau régulier de positions de contacts d'accès vers les microcellules de la mer de portes.

Sur la figure 2, ni les interconnexions ni les contacts d'accès ne sont représentés pour ne pas alourdir le dessin.

Pour un circuit intégré destiné à subir un processus de prédiffusion, l'emplacement et la topographie des macrocellules 30, 32, 34 sont figés, y compris la configuration des interconnexions internes aux macrocellules. Les tranches de circuits intégrés peuvent être préparées à l'avance jusqu'au stade précédant la réalisation des interconnexions.

En fonction des spécifications d'un utilisateur on définit la configuration d'interconnexions nécessaire :

- pour réaliser des cellules logiques (interconnexion locales entre microcellules du réseau remplissant les intervalles entre macrocellules),
- pour réaliser des interconnexions générales entre cellules, entre macrocellules, et entre les cellules et les macrocellules, ces interconnexions générales passant au-dessus de microcellules non utilisées du réseau.

On complète cette configuration avec la configuration (figée) des interconnexions internes dans les macrocellules, pour obenir la topographie complète du circuit intégré.

On fabrique le circuit intégré sur la base de cette topographie complète, ou on termine les tranches prédiffusées en leur appliquant la topographie d'interconnexions dessinée.

Pour un circuit qui n'est pas destiné à subir un processus de prédiffusion, et dont tous les niveaux de masquage sont définis pour une application déterminée, la configuration et la position des macrocellules ne sont pas définies à l'avance. Le processus industriel de conception et de fabrication se déroule de la manière suivante :

Dans une bibliothèque de topographie de macrocellules ayant des fonctions complexes ou spécifiques, dessinées d'une manière compacte, on choisit les macrocellules principales qui permettent de remplir les spécifications du circuit demandé par un utilisateur ; on choisit également un type de microcellule qui pourra être agencé en réseau régulier du type "mer de portes".

Les macrocellules sont dessinées avec une topographie qui permet des prises de contact d'accès à des positions corresondant à celles du réseau de microcellules.

On met en place globalement les macrocellules à des positions espacées les unes des autres dans une surface disponible destinée à contenir la topographie globale du circuit intégré à réaliser. Les macrocellules ont des positions de contacts d'accès qui coïncident alors avec les positions d'un réseau régulier correspondant au pas des microcellules de la mer de portes.

On remplit entièrement l'espace disponible entre les macrocellules, avec des microcellules disposées en rangées adjacentes juxtaposées, sans espacement de routage d'interconnexions entre ces rangées ou entre les rangées et les macrocellules.

On établit la configuration des interconnexions du circuit intégré avec :
- des interconnexions internes dans les macrocellules ; ces interconnexions sont figées ou quasi figées ; elles font partie de la bibliothèque de cellules ;
- des interconnexions locales entre microcellules de la mer de portes, pour réaliser des cellules logiques ;
- des interconnexions générales entre les cellules logiques, entre les macrocellules, et entre les cellules et les macrocellules, ces interconnexions générales passant au-dessus de microcellules non utilisées de la mer de portes.

Enfin, le circuit dont la topographie est ainsi terminée est fabriqué par reproduction de cette topographie sur un substrat de circuit intégré.

Cette architecture particulière permet une facilité de conception très accrue tout en permettant de très bonnes performances grâce à la souplesse qu'on peut avoir sur le choix des positions des interconnexions générales et sur le choix des positions des cellules logiques formées dans la mer de portes.

Par ailleurs, la conception des circuit intégrés va se faire de plus en plus en utilisant dans les bibliothèques de cellules des macrocellules dont la topographie peut être "paramétrisée", c'est-à-dire que ces macrocellules peuvent être dessinées automatiquement par logiciels en fonction de paramètres qu'on introduit dans l'ordinateur d'assistance à la conception. L'invention permettra donc de mettre à profit d'une manière particulièrement intéressante ces nouvelles possibilités.

Enfin, certains circuits intégrés complexes (processeurs de signaux, microprocesseurs) utilisent des mémoires mortes dont la programmation doit se faire à d'autres niveaux que le niveau d'interconnexions et qui se prêtent donc mal à une réalisation sous forme prédiffusée. Le procédé selon l'invention et l'architecture nouvelle proposée ici sont très bien adaptés à des circuits incorporant des mémoires mortes.

**Revendications**

1. Circuit intégré comprenant la structure suivante :

    des macrocellules (30, 32, 34) - correspondant chacune à une fonction complexe ou spécifique de topographie compacte occupent des zones espacées les unes des autres dans la surface disponible pour le circuit,

    les intervalles entre ces zones de macrocellules sont entièrement remplis de rangées adjacentes (42, 44) de transistors sans canaux de routage d'interconnexions entre ces rangées,

    des interconnexions locales sont prévues entre certains de ces transistors pour former des cellules logiques de topographie moins compacte que celle des macrocellules, et

    des interconnexions générales sont prévues au-dessus de transistors non utilisés dans ces rangées, pour relier les cellules entre elles, les macrocellules entre elles, et les cellules avec les macrocellules.

2. Circuit intégré selon la revendication 1, caractérisé en ce que les interconnexions s'étendent entre des positions de contact d'accès aux transistors et aux macrocellules, contacts qui sont tous disposés selon points choisis d'un réseau régulier dont le pas est celui des transistors des rangées adjacentes.

3. Circuit intégré selon la revendication 1 du type prédiffusé, comportant des éléments prédiffusés fixes pouvant être interconnectés d'une manière variable en fonction des besoins lors d'une étape de personnalisation, les éléments prédiffusés fixes comprenant d'une part une zone de réseau prédiffusé de transistors en rangées, destinés à être interconnectés localement lors de la personnalisation pour former des cellules logiques qui elles-mêmes peuvent être reliées entre elles et avec d'autres éléments de circuit par des interconnexions générales également établies lors de la personnalisation, et d'autre part des macrocellules correspondant chacune à une fonction complexe ou spécifique de topographie plus compacte que celle des cellules logiques, caractérisé en ce que les zones de macrocellules (30, 32, 34) occupent des zones séparées les unes des autres et que l'espace entre ces zones de macrocellules est entièrement rempli par la zone de réseau prédiffusé de transistors, celle-ci étant constituée par des rangées adjacentes (42, 44) de transistors,non séparés par des canaux de routage d'interconnexions, permettant, lors de la personnalisation, d'établir entre les zones de macrocellules, d'une part de cellules logiques réalisées au moyen d'interconnexions locales entre les transistors du réseau prédiffusé, d'autre part des interconnexions générales entre ces cellules ou entre les macrocellules ou entre les cellules et les macrocellules, ces interconnexions générales passant au-dessus de transistors non utilisés du réseau prédiffusé.

4. Procédé de réalisation de circuits intégrés selon la revendication 1 dans lequel on utilise une bibliothèque de topographies de cellules de circuits intégrés comprenant d'une part des macrocellules à fonctions électroniques complexes ou spécifiques et d'autre part des microcellules de transistors destinées à être juxtaposées en rangées pour former un réseau régulier de type prédiffusé permettant la réalisation de cellules logiques au moyen d'interconnexions locales entre les microcellules de transistors, les macrocellules pouvant être interconnectées entre elles ou avec les cellules logiques par des interconnexions générales aboutissant à des contacts d'accès prévus à cet effet dans les macrocellules et les microcellules, comprenant les etapes suivantes :

- choisir en fonction des spécification d'un utilisateur les macrocellules à utiliser, et modifier éventuellement les topographies de ces macrocellules en fonction de ces spécifications ;
- mettre en place globalement ces macrocellules à des positions espacées les unes des autres dans la surface disponible destinée à contenir la topographie globale du circuit intégré à réaliser,
- remplir entièrement l'espace entre les macrocellules avec des microcellules disposées en rangées adjacentes juxtaposées sans espacement de routage d'interconnexions entre ces rangées,

- réaliser les configurations d'interconnexions locales entre microcellules pour former des cellules logiques, et d'interconnexions générales entre les cellules, entre les macrocellules, et entre les cellules et les macrocellules, les interconnexions générales passant au-dessus des microcellules,
- fabriquer les circuits intégrés par reproduction sur un substrat de circuit intégré de la topographie ainsi réalisée.

5. Procédé de réalisation de circuits intégrés selon la revendication 4, caractérisé en ce que les contacts d'accès des macrocellules et des microcellules sont placés à des positions d'un réseau régulier de positions ayant un pas constant qui est le pas des microcellules.

## Claims

1. An integrated circuit comprising the following structure:

    macrocells having a compact topography, each corresponding to a complex or specific function, occupy zones spaced out from one another in the area available for the circuit,

    the gaps between said macrocell zones are entirely filled with adjacent rows of transistors without inter-connections routing channels between these rows,

    local interconnections are provided between some of these transistors to form logic cells, the topography of which is less compact than that of the macrocells, and

    general interconnections are provided above the unused transistors in these rows, to connect the cells to one another, the macrocells to one another and the cells to the macrocells.

2. An integrated circuit according to claim 1, characterized in this that the interconnections extend between the positions of the contact points for the transistors and the macrocells, contact points which are all arranged according to chosen points of a regular network, the pitch of which is that of the transistors of adjacent rows.

3. An integrated circuit according to claim 1 of the pre-diffused type, comprising fixed, pre-diffused elements which can be interconnected variably according to need during a custom-building stage, the fixed, pre-diffused elements comprising firstly, a pre-diffused network zone of transistors in rows, designed to be interconnected locally during the custom-building stage, to form logic cells which can themselves be connected to one another and to the other circuit elements by general interconnections which are also made during the custom-building stage, and secondly, macrocells each corresponding to a complex or specific function with a more complex topography than that of the logic cells, characterized in this that the macrocells occupy zones separated from one another and the space between the macrocell zones is entirely filled by the zone of the pre-diffused network of transistors, this zone comprising adjacent rows of transistors, which are not separated by interconnections routing channels, and which can be used, during the custom-building stage, to set up, between the macrocell zones, firstly, logic cells made by means of local interconnections among the transistors of the pre-diffused zone and, secondly, general interconnections among these cells or among the macrocells or between the cells and the macrocells, these general interconnections passing above the unused transistors of the re-diffused network.

4. A process for the making of integrated circuits according to claim 1, characterized in this that a library of topographies of integrated circuit cells is used, this library comprising firstly, macrocells with complex or specific electronic functions and, secondly, transistor microcells designed to be juxtaposed in rows to form a regular network of a pre-diffused type making it possible to build logic cells by means of local interconnections among the transistor microcells, it being possible to connect the macrocells to one another or to the logic cells by general interconnections which end in contact points provided for this purpose in the macrocells and the microcells, comprising the following steps:

- choosing the macrocells to be used according to a user's specifications and modifying the topographies of these macrocells, if necessary, in line with said specifications:
- placing these macrocells as a block in positions which are spaced out from one another in an available area designed to contain the overall topography of the integrated circuit to be made:
- entirely filling the space between the macrocells with microcells arranged in juxtaposed rows without any space for the routing of interconnections between these rows:
- making configurations of local interconnections among microcells to form logic cells, and configurations of general interconnections among the cells, among the macrocells and between the cells and the macrocells, the general interconnections passing above the microcells:
- making the integrated circuit by the reproduction of the topography, thus prepared, on an integrated circuit substrate.

5. A process for the making of integrated circuits according to claim 4, characterized in this that the contact points of the macrocells and the microcells are placed in the positions of a regular network of positions with a constant pitch which is the pitch between the microcells.

## Ansprüche

1. Integrierter Schaltkreis mit folgender Struktur:

Makrozellen (30,32,34) mit kompakter Topographie, jede entsprechend einer komplexen oder spezifischen Struktur, besetzen voneinander entfernte Bereiche auf der für den Schaltkreis zur Verfügung stehenden Oberfläche,

wobei die Lücken zwischen den Bereichen der Makrozellen vollständig mit benachbart liegenden Reihen (42, 44) aus Transistoren ohne verbindende Leitungskanäle zwischen diesen Reihen gefüllt sind,

lokale Verbindungen sind zwischen einigen dieser Transistoren zum Ausbilden logischer Zellen, deren Topographie weniger kompakt ist als die der Makrozellen, vorgesehen und

allgemeine Verbindungen sind oberhalb nicht benutzter Transistoren in diesen Reihen zum Verbinden der Zellen untereinander, der Makrozellen untereinander und der Zellen mit den Makrozellen vorgesehen.

2. Integrierter Schaltkreis nach Anspruch 1, dadurch gekennzeichnet, daß die Verbindungen sich zwischen den Kontaktpunktstellen der Transistoren und der Makrozellen erstrecken, wobei sämtliche Kontakte entsprechend ausgewählten Punkten eines regulären Netzwerkes angeordnet sind, dessen Teilung die der Transistoren der benachbarten Reihen ist.

3. Integrierter Schaltkreis nach Anspruch 1 vom vordiffundierten Typ, mit festen vordiffundierten Elementen, die auf variable Weise entsprechend der Bedürfnisse eines kundenspezifisch geforderten Aufbauabschnittes verbunden weren können, wobei die festen vordiffundierten Elemente einerseites einen vordiffundierten Netzwerkbereich aus in Reihen angeordneten Transistoren, die dazu bestimmt sind, lokal nach kundenspezifischen Anforderungen verbunden zu werden, um logische Zellen zu bilden, die selbst untereinander und mit anderen Schaltkreiselementen durch allgemeine Verbindungen, welche ebenfalls nach kundenspezifischen Anforderungen angelegt sind, verbunden werden können, und andererseits Makrozellen, die jede einer komplexen oder spezifischen Funktion entsprechen, mit einer Topographie, welche kompakter ist als die der logischen Zellen, dadurch gekennzeichnet, daß die Makrozellen (30,32,34) voneinander getrennte Bereiche besetzen und daß der Raum zwischen diesen Makrozellenbereichen vollständig von dem Bereich des vordiffundierten Transistor-Netzwerkes ausgefüllt ist, welcher aus benachbart liegenden Reihen (42,44) aus Transistoren gebildet ist, die nicht durch verbindende Leitungskanäle getrennt sind und es erlauben, nach kundenspezifischen Anforderungen zwischen den Bereichen der Makrozellen einerseits mit Hilfe von lokalen Verbindungen zwischen den Transistoren des vordiffundierten Netzwerkes gebildete logische Zellen, andererseits allgemeine Verbindungen zwischen den Zellen oder zwischen den Makrozellen oder zwischen den Zellen und den Makrozellen einzurichten, wobei diese allgemeinen Verbindungen oberhalb der nichtbenutzten Transistoren des vordiffundierten Netzwerkes verlaufen.

4. Verfahren zum Herstellen integrierter Schaltkreise nach Anspruch 1, bei dem eine Bibliothek der Topographien von integrierten Schaltkreisen verwendet wird, welche einerseits Makrozellen mit komplexen oder spezifischen elektronischen Funktionen und andererseits Transistor-Mikrozellen aufweist, die in Reihen nebeneinanderliegend zum Bilden eines regulären Netzwerkes vom vordiffundierten Typ ausgebildet sind, welches den Aufbau von logischen Zellen mit Hilfe lokaler Verbindungen zwischen den Transistor-Mikrozellen erlaubt, wobei die Makrozellen unter-einander oder mit den logischen Zellen durch allgemeine Verbindungen verbunden werden können, die an zu diesem Zweck in den Makrozellen und in den Mikrozellen vorgesehenen Kontaktpunkten enden, mit den folgenden Schritten:
- Auswählen der zu verwendenden Makrozellen gemäß der Vorgaben eines Benutzers und gegebenenfalls Modifizieren der Topographien dieser Makrozellen nach den Vorgaben;
- gemeinsames Einsetzen dieser Makrozellen an voneinander entfernten Stellen in der verfügbaren Fläche, die so ausgelegt ist, daß sie die globale Topographie des auszubildenden Schaltkreises enthält;
- vollständiges Auffüllen des Raumes zwischen den Makrozellen mit in Reihen nebeneinander benachbart angeordneten Mikrozellen, ohne daß ein Raum für Leitungsverbindungen zwischen diesen Reihen verbleibt,
- Ausbilden der Konfiguration der lokalen Verbindungen zum Aufbau logischer Zellen und von allgemeinen Verbindungen zwischen den Zellen, zwischen den Makrozellen und zwischen den Zellen und den Makrozellen, wobei die allgemeinen Verbindungen über den Makrozellen verlaufen,
- Herstellen der integrierten Schaltkreise durch Reproduktion der so ausgebildeten Topographie auf ein Substrat für einen integrierten Schaltkreis.

5. Verfahren zum Herstellen von integrierten Schaltkreisen nach Anspruch 4, dadurch gekennzeichnet, daß die Kontaktpunkte der Makrozellen und der Mikrozellen an die Stellen eines regulären Netzwerkes mit Stellen konstanter Teilung gelegt sind, die die Teilung zwischen den Mikrozellen ist.

# FIG_1

# FIG_2